# EUROPEAN PATENT APPLICATION

(11) **EP 4 498 360 A1**
(43) Date of publication of application: **29.01.2025**
(21) Application number: 22933580.7
(22) Date of filing: 10.08.2022
(51) Int. Cl.: G10H 1/34, H01H 9/16

(54) **OPERATION DISPLAY DEVICE AND ELECTRONIC MUSICAL INSTRUMENT**

(30) Priority: 22.03.2022 JP 2022045158
(71) Applicant: Casio Computer Co., Ltd., Tokyo 151-8543 (JP)
(72) Inventor: OOTAKE, Manabu, Hamura-shi, Tokyo 205-8555 (JP); MORIYA, Takahiro, Hamura-shi, Tokyo 205-8555 (JP); KATOH, Hirokatsu, Hamura-shi, Tokyo 205-8555 (JP)
(74) Representative: Grünecker Patent- und Rechtsanwälte PartG mbB
(86) International application number: PCT/JP2022/030515
(87) International publication number: WO 2023/181448

(57) **Abstract**

[Problem] to provide an operation display apparatus that can effectively utilize space and improve the operability of touch operations, as well as well as an electronic instrument equipped with such an operation display apparatus.

[Solution] An operation display includes a circuit board 42, a metallic sheet 46 having a plate section 46a, a metallic sheet opening 46b provided in the plate section 46a, and a first leg and a second leg configured to support the plate section 46a on the circuit board 42, and an LED 43 provided on the circuit board 42 in such a manner as to correspond to the metallic sheet opening 46b and configured to change illumination modes according to a change in capacitance caused by a touch operation of the metallic sheet 46, and the first leg and the second leg are bent from an opening edge of the metallic sheet opening 46b towards a side facing the circuit board 42.

## Description

### [Technical Field]

The present invention relates to an operation display apparatus and an electronic instrument.

### [Background Art]

Conventionally, in electronic instruments such as electronic pianos, an operation display apparatus is known to be provided on the case panel. This apparatus includes switches for performing various operations such as demo performances, tone selection, brightness adjustment, and a light source configured to change their illumination modes according to the operations. For example, Patent Literature 1 discloses an electronic keyboard instrument where switches for functions like tone selection are mounted on a circuit board along with switch buttons and indicator lamps for their operation. In this electronic keyboard instrument, the switch buttons and indicator lamps are located on the operation panel.

### [Related Art Literature]

### [Patent Literature]

[Patent Literature 1] Japanese Utility Model Publication No. 7-16993

### [Summary of Invention]

### [Technical Problem]

In recent years, there have been proposed operation display apparatuses including touch switches provided on a touch sensitive panel to perform the various types of operations described above in place of the press or push switches. For a capacitance type touch switch, for example, it is necessary to dispose an electrode for detecting a change in capacitance. When attempting further to dispose a light source or the like in the limited space over the panel, a space where to provide a switch is limited by layout of connection wirings over the substrate. As a result, the switches are provided away from each other or one another, resulting in a risk of a reduction in the operability of touch operations.

An object of the present invention is to provide an operation display apparatus that can effectively utilize space and improve the operability of touch operations, as well as well as an electronic instrument equipped with such an operation display apparatus.

### [Solution to Problem]

An operation display apparatus according to an aspect of the present invention comprises a substrate, a metallic sheet comprising a plate section, an opening section provided in the plate section, and multiple legs configured to support the plate section on the substrate, and a light source provided on the substrate in such a manner as to correspond to the opening section and configured to change illumination modes according to a change in capacitance caused by a touch operation of the metallic sheet, wherein the multiple legs are bent from an opening edge of the opening section towards a side facing the substrate.

### [Advantageous Effect of Invention]

According to the present invention, it is possible to provide an operation display apparatus that can effectively utilize space and improve the operability of touch operations, as well as well as an electronic instrument equipped with such an operation display apparatus.

### [Brief Description of Drawings]

[FIG. 1] FIG. 1 is an overall perspective view of an electronic keyboard instrument according to the embodiment;
[FIG. 2] FIG. 2 is a plan view showing a part of an operation display of the electronic keyboard instrument according to the embodiment;
[FIG. 3] FIG. 3 is a plan view of a touch switch of the electronic keyboard instrument according to the embodiment with a metallic sheet removed;
[FIG. 4] FIG. 4 is a sectional view of the touch switches of the electronic keyboard instrument according to the embodiment, which is a sectional view taken along a line IV-IV in FIG. 2;
[FIG. 5] FIG. 5 is a perspective view of the metallic sheet of the electronic keyboard instrument according to the embodiment; and
[FIG. 6] FIG. 6 is a back view of the part of the operation display of the electronic keyboard instrument according to the embodiment.

### [Description of Embodiments]

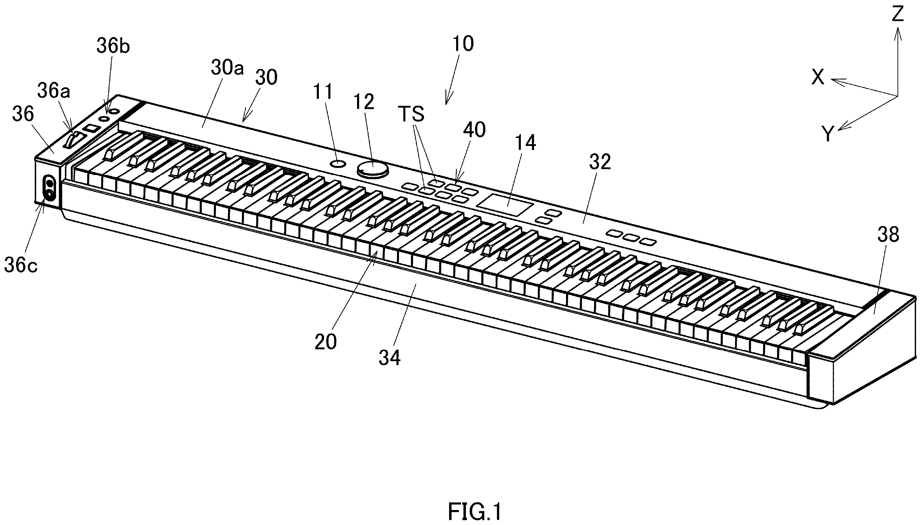

Referring to drawings, an embodiment of the present invention will be described. An electronic keyboard instrument (an electronic instrument) 10 shown in FIG. 1 includes a keyboard 20, made up of multiple white keys 22W and multiple black keys 22B, and a case 30. A control circuit board, not shown, and the like are accommodated in an interior of the case 30. Here, coordinate axes are shown in each of drawings. In the following description, in each drawing, an X-axis direction is referred to as a left-right direction of the electronic keyboard instrument 10 (a positive X-axis direction is referred to as a leftward direction). Similarly, in each drawing, a Y-axis direction is referred to a front-back direction of the electronic keyboard instrument 10 (a positive Y-axis direction is referred to as a forward direction). In each drawing, a Z-axis direction is referred to as an up-down direction of the electronic keyboard instrument 10 (a positive up-down direction is referred to as an upward direction).

The case 30 is of a laterally elongated rectangular shape in which a longitudinal direction follows the left-right direction. The case 30 is formed of a synthetic resin and is divided into an upper case element 32, a lower case element 34, a left case element 36, and a right case element 38. Upper surfaces of the upper case element 32, the left case element 36, and the right case element 38 constitute an acrylic upper panel 30a. A power button 11 for switching on and off a power supply of the electronic keyboard instrument 10, a dial 12 for controlling the volume of musical sound, a liquid crystal display 14, and an operation display (an operation display apparatus) 40 including touch panel type touch switches are provided on the upper surface of the upper case element 32. A pitch bender 36a for controlling the pitch of musical sound by applying a pitch bend to the musical sound, setting buttons 36b for various settings, and the like ae provided on the upper surface of the left case element 36. A headset jack 36c is provided in a front surface of the left case element 36.

In the operation display 40, seven touch switches TS are provided on a left side of the liquid crystal display 14, and two touch switches TS are provided on a right side of the liquid crystal display 14. Further, three touch switches TS are provided on a right side of the two touch switches TS with a predetermined space defined therebetween. In a plan view, each touch switch TS is of a substantially laterally elongated rectangular shape whose four corners are rounded. These touch switches TS are switches for effecting various functions of the electronic keyboard instrument 10, and various operations such as demo performances, tone selection, brightness adjustment are allocated individually to those touch switches TS. As will be described later, an LED (a light source) 43 is provided in each touch switch TS in such a manner that a light emitting side of the LED is directed upwards. Characters or the like are outline printed on areas on the upper panel 30a which correspond to the touch switches TS. When one function is effected by touching one touch switch TS, the LED 43 of the touch switch TS so touched is illuminated, whereby a character or the like which is outline printed on the area on the upper panel 30a which corresponds to the touch switch TS so touched is illuminated.

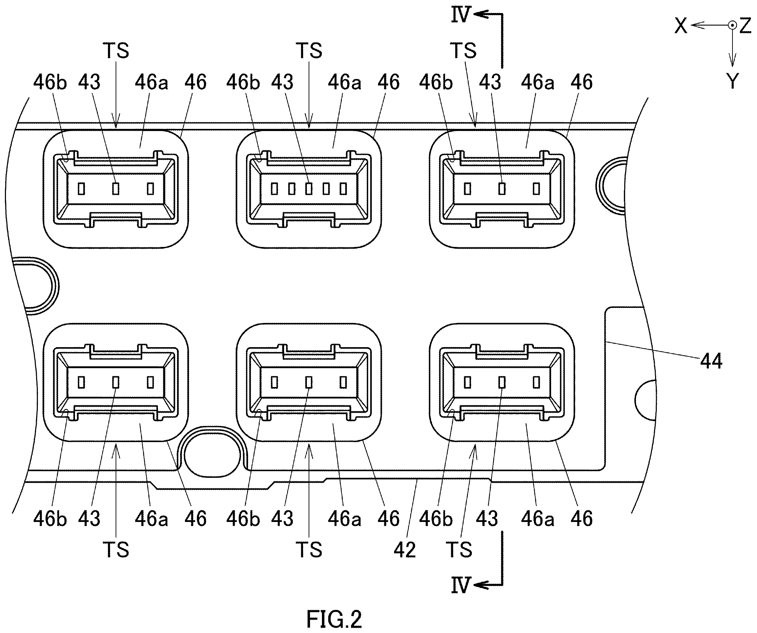

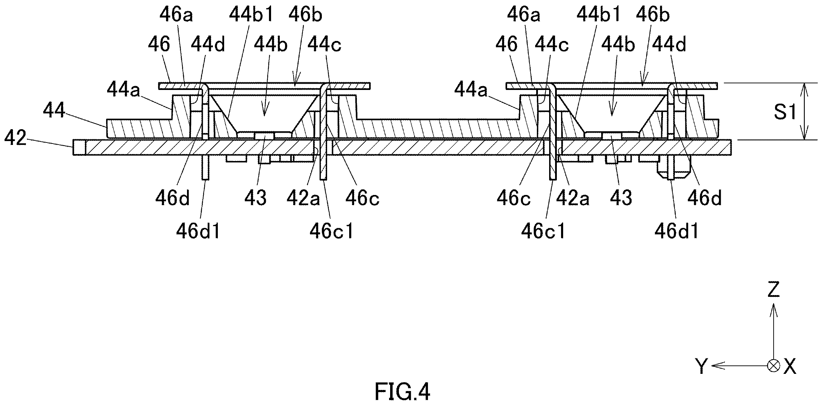

As shown in FIG. 4, the operation display 40 includes a circuit board (a substrate) 42, a reflector 44, and a metallic sheet (a metallic component) 46, which are arranged in a pile sequentially in that order from a bottom side. Further, the upper panel 30a is disposed on an uppermost surface of the operation display 40 (not shown in FIG. 4). In a portion of the operation display 40 shown in FIG. 2, the touch switches TS are provided in two front and back rows along the left-right direction. The operation display 40 is a capacitance type touch panel, and the metallic sheet 46 functions as an electrode. In other words, in the operation display 40, each touch switch detects a change in capacitance caused as a result of the finger of an operator moving towards the metallic sheet 46 during touch operation via the upper panel 30a.

The circuit board 42 is of a substantially laterally elongated rectangular shape and expands over a substantially whole area of the operation display 40. One to five LEDs 43 are provided individually on areas on an upper surface of the circuit board 42 which correspond individually to the touch switches TS. In the area where five LEDs 43 are provided, for example, three LEDs 43 which are illuminated in white and two LEDs 43 which are illuminated in red are combined. Multiple LEDs 43 provided in each touch switch TS are disposed at equal intervals in the left-right direction in such a manner that light emitting sides are directed upwards. In each touch switch TS, illumination modes of the LED 43 are designed to change according to a change in capacitance.

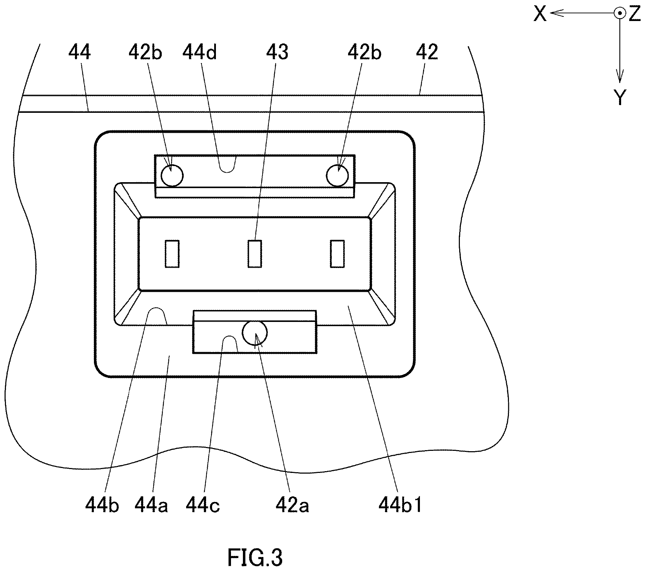

One first attachment hole 42a and two second attachment holes 42b to which the metallic sheet 46 is attached are provided individually on the areas on the upper surface of the circuit board 42 which correspond individually to the touch switches TS (refer to FIG. 3). The first attachment hole 42a and the second attachment holes 42b are provided to face each other in such a manner as to sandwich the LED or LEDs 43. Additionally, the first attachment hole 42a and the second attachment hole 42b are disposed in such a manner that lines connecting these attachment holes 42a, 42b form substantially a regular triangle in a plan view. Various types of wirings are laid out on a lower surface of the circuit board 42. The configuration of the lower surface of the circuit board 42 will be described in detail later.

The reflector 44 is a component formed of a white synthetic resin and has a light reflecting property. As shown in FIGS. 2 to 4, the reflector 44 is of a laterally elongated rectangular plate shape and is disposed between the circuit board 42 and the metallic sheet 46 in the up-down direction. The reflector 44 is provided to surround the light emitting side of the LED 43 within an opening of a metallic sheet opening 46b in the metallic sheet 46, which will be described later. A step section 44a is provided individually on areas on the reflector 44 which correspond individually to the touch switches TS in such a manner as to protrude upwards into a step-like configuration while being sized one size smaller than an external shape of the touch switch TS in a plan view. A light source opening 44b of a substantially laterally elongated rectangular shape is opened in a portion of an upper surface of the step section 44a which is positioned above the LED 43 in such a manner as to allow light from the LED 43 to be emitted therethrough. A first attachment opening 44c of a laterally elongated rectangular shape is provided in a portion of the upper surface of the step section 44a which is positioned above the first attachment hole 42a, and a second attachment opening 44d of a laterally elongated rectangular shape is provided in a portion of the upper surface of the step section 44a which is positioned above the second attachment holes 42b.

As shown in FIGS. 3 and 4, an internal surface is provided on an internal side of the light source opening 44b in such a manner as to be bent inwards from an opening edge of the light source opening 44b to extend as far as the circuit board 42. This internal surface is provided to surround the light emitting side of the LED 43. An opening width of the light source opening 44b gradually expands as the light source opening 44b extends upwards from a lower side (a side facing the circuit board 42) towards an upper side (a side facing the metallic sheet 46) thereof. In other words, the internal surface of the light source opening 44b constitutes a sloping surface 44b1 which slopes outwards from the side facing the circuit board 42 towards the side facing the metallic sheet 46. Light emitted from the LED 43 to reach the sloping surface 44b1 is reflected outwards from the light source opening 44b by the sloping surface 44b1. Here, a polishing treatment is applied to at least a portion of the reflector 44 which corresponds to the sloping surface 44b1, thereby improving the light reflecting property.

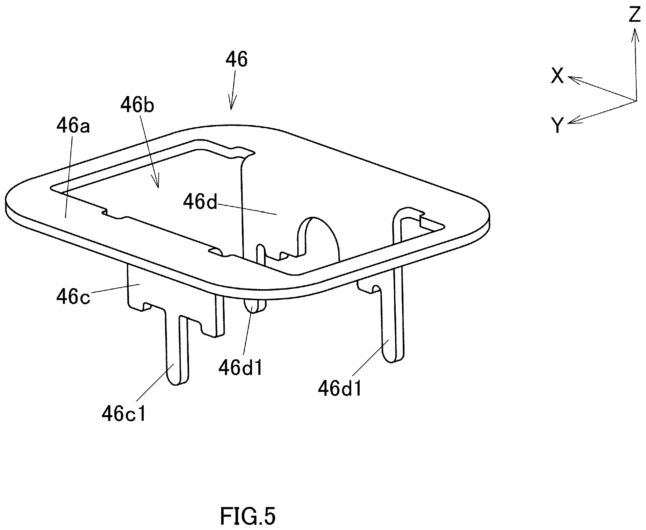

As shown in FIGS. 2 and 5, the metallic sheet 46 has a plate-shaped plate section 46a having a substantially rectangular plate surface. The plate section 46a is disposed above the step section 44a of the reflector 44 in such a manner as to be spaced slightly apart from the step section 44a (refer to FIG. 4). An external shape of the plate section 46a substantially coincides with the external shape of the touch switch TS in plan view. That is, an area on the plate surface of the plate section 46a constitutes an area on the touch switch TS where a touch operation can be performed. The metallic sheet opening (an opening section) 46b is provided in a central portion of the plate section 46a along the opening edge of the light source opening 44b in such a manner as to be opened one size larger than the light source opening 44b. The LED 43 in each touch switch TS is disposed to correspond to the light source opening 44b and the metallic sheet opening 46b so that the light emitting side (an upper side) of the LED 43 is looked upon through the light source opening 44b and the metallic sheet opening 46b.

The metallic sheet 46 has multiple legs of a first leg 46c and a second leg 46d which are bent substantially at right angles from the opening edge of the metallic sheet opening 46b towards the circuit board 42. The first leg 46c is bent from one side in four sides which form the opening edge of the metallic sheet opening 46b. An upper part of the first leg 46c is formed into a plate-shaped section whose plate surfaces are directed in the front-back direction and is configured to be inserted into the first attachment opening 44c in the reflector 44, and a lower part of the first leg 46c is formed into a substantially prism-shaped section which protrudes from a central portion in the left-right direction of the upper part. The second leg 46d is bent from a side in the four sides which form the opening edge of the metallic sheet opening 46b which lies opposite to the side from which the first leg extends. An upper part of the second leg 46d is formed into a plate-shaped section whose plate surfaces are directed in the front-back direction and is configured to be inserted into the second attachment opening 44d in the reflector 44, and a lower part of the second leg 46d is formed into substantially prism-shaped sections which protrude individually from end portions in the left-right direction of the upper part.

A distal end portion of the part of the first leg 46c which is formed into the substantially prism-shaped section constitutes a first attachment section 46c1 and is attached to the first attachment hole 42a of the circuit board 42. Distal end portions of the substantially prism-shaped sections constituting the part of the second leg 46d constitute second attachment sections 46d1 and are attached individually to the second attachment holes 42b of the circuit board 42. The first attachment section 46c1 and the second attachment sections 46d1 are inserted into the first attachment hole 42a and the second attachment holes 42b, respectively, and are then joined to a lower surface side of the circuit board 42 with solder (not shown), whereby the first leg 46c and the second leg 46d are attached to the circuit board 42. As a result, the plate section 46a is supported on the circuit board 42 with the reflector 44 sandwiched between them. The plate section 46a is supported stably on the circuit board 42 by being supported at three points of the first attachment section 46c1 and the two second attachment sections 46d1 sandwiching the LED 43. Here, with the metallic sheet 46 supported on the circuit board 42, a depth dimension S1 (refer to FIG. 4) defined from the opening of the metallic sheet opening 46b to the circuit board 42 is, for example, 5 mm.

Here, as shown in FIG. 4, the first attachment opening 44c and the second attachment opening 44d which are provided in the reflector 44 are also opened within the opening of the light source opening 44b at upper portions thereof. As a result, in such a state that the first leg 46c is inserted in the first attachment opening 44c and the second leg 46d is inserted in the second attachment opening 44d, a part of the first leg 46c and a part of the second leg 46d are exposed within the opening of the light source opening 44b and within the opening of the metallic sheet opening 46b. Among the light emitted from the LED 43, light components which reach the first leg 46c and the second leg 46d which are exposed within the openings are reflected to the outside of the light source opening 44b and the outside of the metallic sheet opening 46b by the first leg 46c and the second leg 46d.

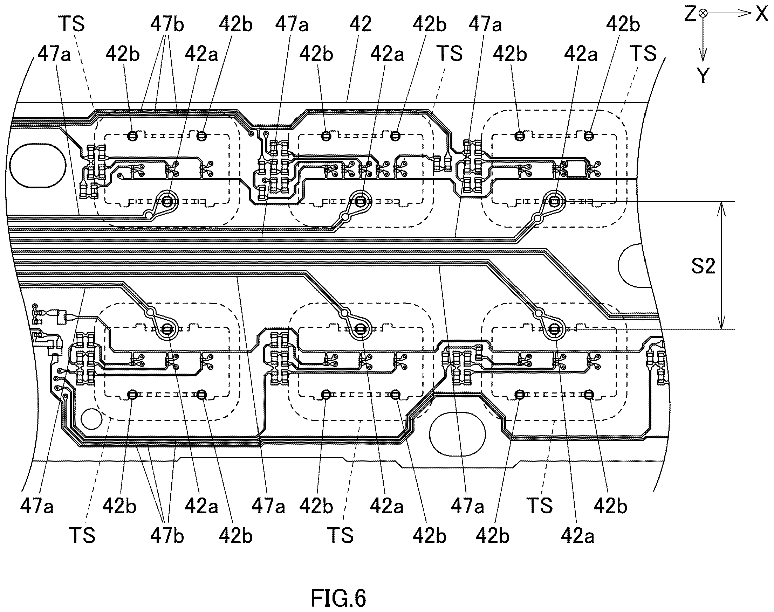

The configuration of the lower surface of the circuit board 42 will be described in detail. As shown in FIGS. 4 and 6, in each of the touch switches TS which are provided in the two front and back rows along the left-right direction (each of areas surrounded by a broken line in FIG. 6), the first attachment hole 42a is provided in an inward portion of the circuit board 42, and the two second attachment holes 42b are provided in an outward portion of the circuit board 42. In other words, the first attachment hole 42a is provided in a position lying closer to a center in the front-back direction of the circuit board 42, and the two second attachment holes 42b are provided in a position lying closer to an external edge in the front-back direction of the circuit board 42. A dimension S2 defined between the first attachment holes 42a which lie adjacent to each other in the front-back direction is, for example, 28 mm.

Multiple first wirings (connection wirings) 47a extending individually from the first attachment holes 42a and multiple second wirings 47b extending individually from the LEDs 43 are printed on the lower surface of the circuit board 42. In each of the first wirings 47a, one end is electrically connected to the first leg 46c of the metallic sheet 46 which is inserted in the first attachment hole 42a via the solder, and the other end extends as far as an IC, not shown, which is provided on the lower surface of the circuit board 42. As shown in FIG. 6, at a portion of the circuit board 42 where the touch switches TS are provided in the two front and back rows along the left-right direction, the first wirings 47a extending from the first attachment holes 42a are laid out between the touch switches TS which lie adjacent to each other in the front-back direction (between the first attachment holes 42a) to extend as far as the IC along the left-right direction. As a result, the first wirings 47a are provided in a position where the first wirings 47a do not overlap the areas where the touch switches TS are provided in the up-down direction.

In each of the second wirings 47b, one end is electrically connected to the LED 43 via the solder, and the other end extends as far as the IC. The second wiring 47b is laid out from a position lying between the first attachment hole 42a and the second attachment holes 42b, that is, a position where the LEDs 43 are provided to the outside of the circuit board 42, and the second wirings 47d extending individually from the touch switches TS are bundled up together to extend as far as the IC. In the circuit board 42, a signal on a change in capacitance caused by a touch operation of the touch switch TS is inputted into the IC by way of the first leg 46c, and a signal for controlling illumination modes of the LEDs 43 of the relevant touch switch TS according to the change in capacitance is outputted to the LEDs 43 of the touch switch TS.

As explained above, the operation display 40 according to the present embodiment includes the circuit board 42, the metallic sheets 46 each having the plate section 46a, the metallic sheet opening 46b provided in the plate section 46a, and the first leg 46c and the second leg 46d which support the plate section 46a on the circuit board 42, and the LEDs 43 provided on the circuit board 42 in such a manner as to correspond individually to the metallic sheet openings 46b and configured to change the illumination modes thereof according to a change in capacitance caused by a touch operation of the corresponding metallic sheets 46. Then, the first leg 46c and the second leg 46d are bent from the opening edge of the metallic sheet opening 46b towards the side facing the circuit board 42.

Here, in the event that a configuration is adopted in which in the operation display 40, the first leg 46c and the second leg 46d of the metallic sheet 46 are bent from an external edge of the metallic sheet 46, the first attachment hole 42a and the second attachment holes 42b are provided in positions on the circuit board 42 which overlap the external edge of the metallic sheet 46 in the up-down direction. As a result, in the case that a width in the front-back direction of the circuit board 42 is limited, when attempting to provide the touch switches TS in the two front and back rows along the left-right direction, a space between the touch switches TS which lie adjacent to each other in the front-back direction becomes narrow, and hence, it is not possible to secure a sufficient space for layout of the first wirings 47a between the touch switches TS which lie adjacent to each other in the front-back direction.

In contrast with this, due to the operation display 40 according to the present embodiment being configured as described above, the first attachment hole 42a and the second attachment holes 42b are provided in the positions overlapping the opening edge of the metallic sheet opening 46b in the metallic sheet 46 in the up-down direction. With this configuration, the first wirings 47a can be laid out from the positions which overlap the insides of the areas where the touch switches TS are provided in the up-down direction on the lower surface of the circuit board 42. As a result, even in the case that the width in the front-back direction of the circuit board 42 is limited, it is possible to secure the sufficient space for layout of the first wirings 47a between the touch switches TS which lie adjacent to each other in the front-back direction while providing the touch switches TS in the two front and back rows along the left-right direction by providing the first attachment holes 42a at the inward portions of the circuit board 42.

In this way, with the operation display 40, even in the case that the width in the front-back direction of the circuit board 42 is limited in the limited space on the upper panel 30a, the touch switches TS can be provided in the two front and back rows along the left-right direction, thereby making it possible to make effective use of the space on the circuit board 42. As a result of this, the touch switches TS can be disposed in such a manner as to lie close to one another in the limited space on the upper panel 30a, thereby making it possible to improve the operability of touch operations.

Of the first leg 46c and the second leg 46d in the operation display 40, the first leg 46c is connected with the first wiring 47a. As a result, the first wiring 47a can be laid out from the first attachment hole 42a to which the first leg 46c is attached, thereby making it possible to make more effective use of the space on the circuit board 42.

Additionally, the operation display 40 includes the reflector 44 having the light reflecting property and provided to surround the light emitting side of the LED 43 within the opening of the metallic sheet opening 46b. With this configuration, among the light emitted from the LED 43, light components travelling towards the reflector 44 can be reflected towards the opening of the metallic sheet opening 46b by the reflector 44, thereby making it possible to enhance the brightness of light emitted towards the opening of the metallic sheet opening 46b. As a result, it is possible to enhance the visibility of the operation display 40 and further improve the operability of touch operations.

In the operation display 40, the reflector 44 has the sloping surface 44b1 which slopes outwards from the side facing the circuit board 42 towards the side facing the metallic sheet opening 46b. With this configuration, among the light emitted from the LED 43, light components traveling towards the side facing the reflector 44 can be reflected effectively towards the opening side of the metallic sheet opening 46b by the sloping surface 44b1 of the reflector 44. As a result, the brightness of light emitted towards the opening side of the metallic sheet opening 46b can be enhanced further.

Additionally, in the operation display 40, the plate surface of the plate section 46a of the metallic sheet 46 is of the substantially rectangular shape. Here, supposing that the sizes of the touch switches TS provided in the upper panel 30a are equal, the surface area of the plate surface of the plate section 46a becomes larger when the plate surface is configured to have a substantially rectangular shape than when the plate surface is configured to have a substantially circular shape. Hence, in the case that the size of the touch switch TS so provided is limited, a range where to enable a touch operation can be expanded in the limited space by giving a substantially rectangular shape to the plate surface of the plate section 46a. As a result of this, the sensitivity of a touch operation performed on the touch switch TS can be enhanced, thereby making it possible to improve the operability of touch operations.

In the operation display 40, the part of the first leg 46c and the part of the second leg 46d of the metallic sheet 46 are exposed within the opening of the metallic sheet opening 46b. With this configuration, among the light emitted from the LED 43, light components travelling towards the first leg 46c and the second leg 46d can be reflected to the opening side of the metallic sheet opening 46b by one of the first leg 46c and the second leg 46d. As a result, Among the light emitted from the LED 43, light components traveling towards other locations than the opening side of the metallic sheet opening 46b can be reflected towards the opening side of the metallic sheet opening 46b by any one of the reflector 44, the first leg 46c and the second leg 46d, thereby making it possible to further enhance the brightness of light emitted to the opening side of the metallic sheet opening 46b.

In the operation display 40, the first attachment section 46c1 of the first leg 46c and the two second attachment sections 46d1 of the second leg 46d of the metallic sheet 46 support the plate section 46a on the circuit board 42 at the three points sandwiching the LED 43. With this configuration, since the plate section 46a is supported stably on the circuit board 42, the stability of a touch operation can be enhanced, thereby making it possible to further improve the operability of touch operations.

The electronic keyboard instrument 10 according to the present embodiment includes the operation display 40. With this configuration, even in the case that the space on the upper panel 30a is limited, the touch switches TS can be provided in such a manner as to lie close to one another, thereby making it possible to improve the operability of touch operations. As a result, the electronic keyboard instrument 10 can be realized in which the operability of touch operations on the operation display 40 is improved while achieving miniaturization of the electronic keyboard instrument 10.

Here, the embodiment of the present invention that has been described heretofore is presented as the example, and hence, there is no intention to limit the scope of the present invention by the embodiment. The novel embodiment can be carried out in other various forms, and various omissions, replacements, and modifications can be made thereto without departing from the spirit and scope of the present invention. Those resulting embodiments and modified examples thereof are included in the scope and gist of the present invention and are also included in the scope of inventions claimed for patent under claims below and their equivalents. For example, while the pitch bender is exemplified as a control device in the present embodiment, other control device including a modulation wheel or the like may be adopted as a control device. Additionally, while the electronic keyboard instrument is exemplified as an electronic instrument in the present embodiment, other electronic instruments including those having no keyboard may be adopted as an electronic instrument.

### [Industrial Applicability]

According to the present invention, it is possible to provide an operation display apparatus that can effectively utilize space and improve the operability of touch operations, as well as well as an electronic instrument equipped with such an operation display apparatus.

### [Reference Sign List]

10 Electronic keyboard instrument
11 Power button
12 Dial
14 Liquid crystal display
20 Keyboard
30 Case
30a Upper panel
32 Upper case element
34 Lower case element
36 Left case element
36a Pitch bender
36b Setting button
36c Headset jack
38 Right case element
40 Operation display
42 Circuit board
42a First attachment hole
42b Second attachment hole
43 LED
44 Reflector
44a Step section
44b Light source opening
44b1 Sloping surface
44c First attachment opening
44d Second attachment opening
46 Metallic sheet
46a Plate section
46b Metallic sheet opening
46c First leg
46c1 First attachment section
46d Second leg
46d1 Second attachment section
47a First wiring
47b Second wiring
S1 Dimension
S2 Dimension
TS Touch switch

## Claims

1. An operation display apparatus comprising:
a substrate;
a metallic sheet comprising a plate section, an opening section provided in the plate section, and multiple legs configured to support the plate section on the substrate; and
a light source provided on the substrate in such a manner as to correspond to the opening section and configured to change illumination modes according to a change in capacitance caused by a touch operation of the metallic sheet,
wherein the multiple legs are bent from an opening edge of the opening section towards a side facing the substrate.

2. The operation display apparatus according to claim 1,
wherein at least one of the multiple legs is connected with a connection wiring provided on the substrate.

3. The operation display apparatus according to claim 1 or 2, comprising:
a reflector having a light reflecting property and provided to surround a light emitting side of the light source within an opening of the opening section.

4. The operation display apparatus according to claim 3,
wherein the reflector comprises a sloping surface sloping outwards from a side facing the substrate towards a side facing the opening section.

5. The operation display apparatus according to any one of claims 1 to 4,
wherein a plate surface of the plate section is of a substantially rectangular shape.

6. The operation display apparatus according to any one of claims 1 to 5,
wherein parts of the multiple legs are exposed within an opening of the opening section.

7. The operation display apparatus according to according to any one of claims 1 to 6,
wherein the multiple legs support the plate section on the substrate at least at three points sandwiching the light source.

8. An electronic instrument comprising:
the operation display apparatus according to any one of claims 1 to 7.
